# EUROPÄISCHE PATENTANMELDUNG

(11) **EP 2 843 573 A1**
(43) Veröffentlichungstag der Anmeldung: **04.03.2015**
(21) Anmeldenummer: 14180842.8
(22) Anmeldetag: 13.08.2014
(51) Int. Cl.: G06F 17/50

(54) **Verfahren zum Entwurf einer elektronischen Schaltung sowie Vorrichtung hierzu**

(30) Priorität: 30.08.2013 DE 102013014426
(71) Anmelder: Liebherr-Elektronik GmbH, 88131 Lindau (DE)
(72) Erfinder: Birkholz, Dr. rer. nat. Harald, 88131 Lindau (DE); Pearman, Ph. D. Dominic, 88131 Lindau (DE); Hofmann, Dipl.-Ing. Roman, 88239 Wangen (DE); Cremer, Dr.-Ing. Ralf, 88131 Lindau (DE)
(74) Vertreter: Laufhütte, Dieter

(57) **Zusammenfassung**

Die Erfindung betrifft ein Verfahren zum Entwurf einer elektronischen Schaltung für ein elektronisches Gerät auf Grundlage einer Datenbank, die ein oder mehrere Schaltungsteilmodule bzw. Schaltungssysteme enthält, die jeweils durch eine abstrakte Modul- und/oder Systemspezifikation in streng vorgegebener Form definiert sind, wobei eine formale Produktsuchanfrage auf Grundlage einer abstrakten Produktspezifikation in streng vorgegebener Form durch den Nutzer eingegeben wird und ein Kombinatorikmodul in Abhängigkeit der Produktsuchanfrage aus einer oder mehreren Instanzen der gespeicherten Teilmodule und/oder Systeme ein oder mehrere Systementwürfe erstellt, insbesondere eine Liste von möglichen Systementwürfen erstellt.

## Beschreibung

Die Erfindung betrifft ein Verfahren zum Entwurf elektronischer Schaltungen für elektronische Geräte.

Der Entwurf von spezifischen elektronischen Schaltungen für individuelle Geräte erfordert eine Reihe von aufwändigen Verfahrensschritten. Dazu gehören z. B. die formale Spezifikation des gewünschten Endproduktes, der nachfolgende manuelle Entwurf einer geeigneten elektronischen Schaltung zur Ausführung der gewünschten Zielfunktion sowie ein nachfolgender ausgiebiger Test des Schaltungsentwurfs auf Funktionsfähigkeit. Neben der reinen Funktionsfähigkeit als Kriterium sind für den Schaltungsentwurf zahlreiche andere Anforderungen denkbar. Beispielsweise soll der Schaltungsentwurf auch Vorgaben an die aufzuwenden Entwurfs- und Herstellungskosten berücksichtigen.

Dem Fachmann stehen für den Schaltungsentwurf bisher diverse rechnergestützte Hilfsmittel zur Verfügung, die jedes für sich Teilaufgaben während der Gesamtprozedur übernehmen bzw. dem Fachmann unterstützend bei Seite stehen. Allerdings existiert derzeit kein rechnergestütztes Verfahren, das den vollautomatisierten Entwurf einer elektronischen Schaltung abdeckt. Bekannt sind zudem lediglich Teillösung auf Grundlage eines modellbasierten Designs, systematischer Fallunterscheidungen sowie Hilfsmittel zur automatischen Verifikation entsprechend erstellter Schaltungsentwürfe. Keine dieser Teillösungen deckt jedoch eine volle Automatisierung des gesamten Schaltungsentwurfs ab.

Die verwendeten modellbasierten Designs werden vorwiegend für den Entwurf von eingebetteten Systemen verwendet und münden in Verfahren, wie Rapid Prototyping, Softwaretest und Verifikation. Dazu werden formal differential-algebraische Gleichungssysteme aufgestellt, die das Systemverhalten erfassen. Mit modernen grafischen Benutzeroberflächen werden Kontrollstrukturen entworfen, die die Systemspezifikation in den modellierten Effekten erfüllen. Das Ergebnis kann während des Designverfahrens auf Fehler geprüft werden. Das Endergebnis ist ein Entwurf der Kontrollstrukturen im Rahmen des eingegebenen Systementwurfs. Während des modellbasierten Designs ist jedoch für den konkreten Entwurf der Schaltung die verstandesmäßige Eingabe des bearbeitenden Ingenieurs notwendig. Eine automatisierte Entwurfserstellung ist auch dadurch nicht abgedeckt.

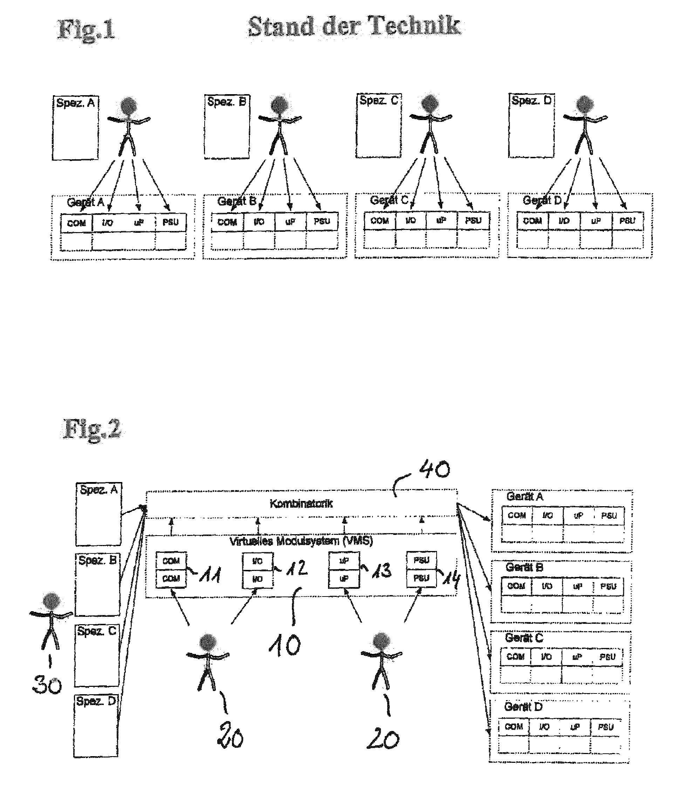

Fig. 1 zeigt schematisch den notwendigen Entwicklungsaufwand gemäß dem Stand der Technik. Für die Entwicklung von unterschiedlichen elektronischen Geräten A, B, C, D wird dem zuständigen Entwickler eine Spezifikation des gewünschten Gerätes zur Verfügung gestellt. Auf Grundlage seines Fachwissens entwirft der Entwickler ein Gerät A, B, C, D, das sich aus einzelnen Teilkomponenten zusammensetzt, wie beispielsweise einer Kommunikationsschnittstelle, eines Ein- und Ausgabegerätes, eines Mikroprozessors sowie einer Energieversorgung PSU. Die Auswahl der passenden Teilmodule hat der Entwickler jedoch selbst zu treffen.

Die Aufgabe der vorliegenden Erfindung besteht nun darin, ein geeignetes Verfahren aufzuzeigen, das den vollständigen Entwurf von Schaltungen für ein elektronisches Gerät automatisiert.

Diese Aufgabe wird durch das Verfahren gemäß den Merkmalen des Anspruchs 1 gelöst. Vorteilhafte Ausgestaltungen des Verfahrens sind Gegenstand der abhängigen Unteransprüche.

Gemäß Anspruch 1 wird ein Verfahren zum Entwurf einer elektronischen Schaltung für ein elektronisches Gerät vorgeschlagen, das eine Datenbank verwendet, in der ein oder mehrere Schaltungsteilmodule und/oder Schaltungssysteme enthalten sind, die jeweils durch eine abstrakte Modul- und/oder Systemspezifikation in streng vorgegebener Form definiert und beschrieben sind. Die Teilmodule bzw. Teilsysteme können analoge oder digitale Module sein.

Der Bediener kann in einem ersten Verfahrensschritt das gewünschte Zielprodukt über eine dafür vorgesehene Eingabemaske spezifizieren. Das gewünschte Zielprodukt entspricht einer Produktsuchanfrage, die formal auf Grundlage einer abstrakten Produktspezifikation in streng vorgegebener Form eingegeben wird.

Beispielsweise kann der Nutzer das gewünschte Zielsystem computergestützt mit Hilfe einer grafischen Nutzeroberfläche definieren, um eine formale Produktsuchanfrage in streng vorgegebener Form zu erreichen.

In einem weiteren Schritt durchsucht ein Kombinatorikmodul in Abhängigkeit der eingegebenen Produktsuchanfrage die Schaltungsmoduldatenbank mit den mehreren Schaltungsteilmodulen bzw. Schaltungssystemen und erstellt eine Liste von möglichen Systementwürfen, die jeweils für sich ein oder mehrere Instanzen der gespeicherten Teilmodule und/oder Systeme in geeigneter Weise miteinander kombinieren.

Das erfindungsgemäße Verfahren stellt einen vollautomatisierten Ablauf des Schaltungsentwurfs von elektronischen Geräten dar. Zwischen den einzelnen Schritten ist kein verstandesmäßiger Eingriff des Nutzers notwendig. Nach der Eingabe der formalen Produktsuchanfrage liefert das Verfahren automatisch eine Liste möglicher Systementwürfe, die die gestellten Bedingungen der Produktsuchanfrage erfüllen.

Das erfindungsgemäße Verfahren ermöglicht eine schnellere, qualitativ hochwertigere und kostengünstigere Entwicklung von Elektronikprodukten.

Die einzelnen Systementwürfe der ausgegebenen Liste können vorzugsweise pareto-optimale Lösungen für Produkte aus Baugruppeninstanzen des Datenbestands darstellen. Zur besseren Übersicht ist es sinnvoll, wenn die erstellen Systementwürfe innerhalb der Liste nach einzelnen Zielsetzungen sortiert sind. Die formale Produktspezifikation der Produktsuchanfrage erfolgt idealerweise anhand von Leistungsmerkmalen und Kostenmerkmalen, die für sich genommen unterschiedliche Zielsetzungen darstellen können.

Vorzugsweise wird die Liste an Systementwürfen auf Grundlage einer kombinatorischen Suche mit den Kombinationen mit Wiederholungen aus der Datenbank als Suchraum und der Produktsuchanfrage als Suchkriterium erstellt. Die Kombinationen als Wiederholung sind ein fester Begriff der abzählenden (mathematischen) Kombinatorik. Der Tatsache, dass Elemente der Datenbank beliebig oft instanziiert werden können, kommt daher eine gesonderte Bedeutung zu.

In einer besonders bevorzugten Ausführungsform basiert die Suchstrategie der kombinatorischen Suche auf einer Breitensuche mit einer Warteschlange von Teilproblemen erweiterbarer Netzlisten. Die Teilprobleme können neben dem funktionalen Vergleich, d. h. der Prüfung ob der mögliche Systementwurf die grundlegende elektronische Funktion des Zielproduktes erfüllt, auch anderweitige Teilprobleme, wie beispielsweise Herstellungskosten, Bauteilqualität, etc. betreffen.

Idealerweise erlaubt das Abstraktionsniveau des erfindungsgemäßen Verfahrens den Entwurf von Netzlisten analog-digital gemischter Schaltkreise ohne dabei ein abstrakteres Modell auf Registertransferniveau zu verwenden.

In diesem Zusammenhang ist es insbesondere sinnvoll, wenn die kombinatorische Suche auf Heuristiken zurückgreift, die speziell auf die Anwendung für elektronische Designs angepasst wurden. Die Urteile in den verwendeten Heuristiken können durch eine Sprache in strenger Form vorbereitet sein. Diese Form ist im Detail gerade so weit gefasst, dass alle relevanten Baugruppen unterscheidbar sind und so eng gefasst, dass kaum Mehrdeutigkeiten möglich sind. Diese Form erlaubt vorzugsweise eine Skalierung der Baugruppen, indem die Beschreibung von Baugruppen der Beschreibung von Entwürfen für Produkte in den die Suche bestimmenden Aspekten gleicht. Daher können idealerweise Baugruppen im Laufe der Nutzung ihrerseits von kleineren Baugruppen erzeugt werden.

Besonders vorteilhaft besteht die Möglichkeit, geeignete Systementwürfe des Verfahrens für die spätere Verwendung zum Entwurf anderweitiger Geräte in der Datenbank als Teilmodul bzw. -system zu speichern. Die Datenbank kann folglich laufend erweitert werden. Die Datenbank ist vorzugsweise jederzeit um neue Teilmodule- bzw. -systeme erweiterbar. Modulentwickler können folglich im Hintergrund an neuen Teilmodulen arbeiten und diese in der Datenbank mit der passenden Teilmodulbeschreibung hinterlegen.

Für die kombinatorische Suche wird der durchsuchte Raum, d. h. der Datenbestand der zur Verfügung stehenden Datenbank, durch allgemeine Beschränkungen für die Kosten und/oder für die Bewertung von Baugruppen eingeschränkt. Für die Durchführung der kombinatorischen Suche ist es daher zweckmäßig, dass die Produktspezifikation und/oder die Modul- und/oder Systemspezifikation eine funktionale Beschreibung und/oder allgemeine Einschränkungen umfassen.

Auf Grundlage der funktionalen Beschreibung wird ein funktionaler Vergleich zwischen dem gewünschten Zielprodukt und den zur Verfügung stehenden Teilmodulen bzw. Teilsysteme der Datenbank angestellt. Die funktionale Beschreibung kann auf einer Modellierung der Funktionalität unter Verwendung von Verbandsautomaten basieren. Verbandsautomaten sind endliche Automaten, deren Alphabet partiell geordnet ist. Dies liefert das entscheidende Kriterium des funktionellen Vergleichs zwischen möglichen Entwürfen und formalen Produktanfragen. Neben der funktionalen Beschreibung kann zudem eine Beschreibung der Anschlussstellen der einzelnen Teilmodule bzw. Teilsysteme bzw. der Produktspezifikation vorliegen und für die kombinatorische Suche Berücksichtigung finden.

Zu den allgemeinen Einschränkungen zählen insbesondere wirtschaftliche Kenngrößen, woraus sich eine Möglichkeit der Beschränkung des Suchraumes hinsichtlich der anfallenden Produktionskosten bzw. Herstellungskosten der Systementwürfe ergeben. Weiterhin umfassen diese allgemeinen Einschränkungen Entwicklerheuristiken, die eine Erfahrungsbeurteilung einzelner Teilmodule bzw. Teilsysteme der Datenbank betreffen. Insbesondere kann der Bestand der Datenbank durch physikalische Belastungstests qualifiziert sein, die Risiken für das Versagen von elektronischen Funktionen und der kundenspezifischen Bedingungen erfassen.

Weiterhin kann die Produktspezifikation und/oder die Teilmodul- und/oder Teilsystemspezifikation Klauseln für Datenblattinformationen umfassen.

Idealerweise wird die Liste geeigneter Systementwürfe zusammen mit einem Vorschlag für die mögliche Verschaltung erstellt.

Die Erfindung betrifft weiterhin eine Vorrichtung zur Durchführung des erfindungsgemäßen Verfahrens bzw. einer vorteilhaften Ausgestaltung des Verfahrens. Die Vorrichtung umfasst insbesondere eine Rechnereinheit, die eine grafische Nutzeroberfläche generiert, sowie ein Kombinatorikmodul. Daneben steht eine Schaltungsmodulbibliothek als Datenbank zur Verfügung, die eine Vielzahl von Schaltungsteilmodulen bzw. Schaltungsteilsysteme enthält. Die Vorteile und Eigenschaften der Vorrichtung entsprechen offensichtlich denen des erfindungsgemäßen Verfahrens, weshalb an dieser Stelle auf eine wiederholende Beschreibung verzichtet wird.

Neben der Vorrichtung betrifft die Erfindung zudem ein auf einem Datenträger gespeichertes Programm, das die notwendigen Steuerbefehle zur Durchführung des erfindungsgemäßen Verfahrens bzw. einer vorteilhaften Ausführung des erfindungsgemäßen Verfahrens enthält.

Weitere Vorteile und Eigenschaften der Erfindung werden im Folgenden anhand von Zeichnungen näher erläutert. Es zeigen:
- Fig. 1:: den Entwicklungsprozess gemäß dem Stand der Technik,
- Fig. 2:: den Entwicklungsprozess gemäß dem erfindungsgemäßen Verfahren,
- Fig. 3:: eine schematische Darstellung, die die Einordnung des erfindungsgemäßen Verfahrens in der Wertschöpfungskette darstellt.
- Fig. 4:: eine Übersicht des Gesamtkonzeptes der vorliegenden Erfindung und
- Fig. 5:: eine Diagramm-Darstellung für das algorithmische Nutzungskonzept des Verfahrens.

Fig. 2 zeigt den Entwicklungsprozess gemäß dem erfindungsgemäßen Verfahren. Das erfindungsgemäße Verfahren beruht auf der Verwendung einer Schaltungsmodulbibliothek 10, die ein virtuelles Modulsystem (VMS) umfasst. In dieser Datenbank 10 sind elektronische Schaltungsmodule abstrakt in strenger vorgegebener Form beschrieben und gespeichert. Die Datenbank 10 wird durch einzelne Modulentwickler 20 erstellt, gewartet und kontinuierlich ergänzt.

Der Produktentwickler 30 definiert in Abhängigkeit individueller Kundenwünsche oder spezifischer Systemanforderungen eine formale Produktsuchanfrage Spez. A, Spez. B., Spez. C, Spez. D und führt diese der Rechnereinheit zur Durchführung des Verfahrens zu. Das Kombinatorikmodul 40 der Rechnereinheit wertet die erstellten Produktsuchanfragen Spez. A, Spez. B, Spez. C, Spez. D aus und erstellt darauf basierend eine Liste geeigneter Systementwürfe Gerät A, Gerät B, Gerät C, Gerät D.

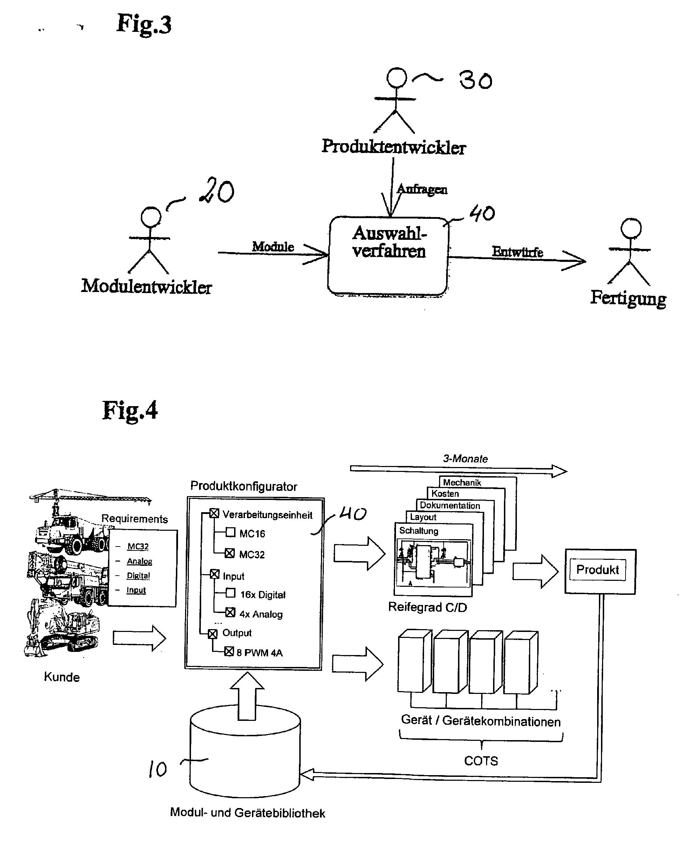

Konkret führt das Kombinatorikmodul 40 eine kombinatorische Suche durch die Schaltungsmodulbibliothek 10 durch, um passende Schaltungsteilmodule 11, 12, 13, 14 zu einem passenden Systementwurf eines Gerätes zusammenzusetzen. Durch das Verfahren wird folglich der komplette Entwicklungsprozess von der Erfassung einer Produktanfrage bis hin zum Aufbau eines physischen Prototyps aus den Baugruppen mit abschließenden Anpassungen im Detail unterstützt. Figur 3 soll diesen Prozess innerhalb der Wertschöpfungskette verdeutlichen. Es sind lediglich Eingaben der Produktentwickler 30 sowie der Modulentwickler 20 notwendig. Der Schaltungsentwurf erfolgt vollautomatisiert durch ein geeignetes Auswahlverfahren, das im Ergebnis eine Liste passender Systementwürfe für die anschließende Produktfertigung ausgibt.

Das gewünschte Produkt wird computergestützt mit einer grafischen Nutzeroberfläche in streng vorgegebener Form konfiguriert. Produkte sowie Schaltungsteilmodule 11, 12, 13, 14 werden mit ihren Anschlussstellen, einer funktionalen Beschreibungen, wirtschaftlichen Kenngrößen und Dokumentationsreferenzen in einer formalen Sprache in strenger, vorgegebener Form erfasst. Beispielhaft sind in der Schaltungsmodulbibliothek der Figur 2 Schaltungsteilmodule verschiedener Bauteilkategorien gespeichert. Im Einzelnen enthält die Bibliothek 10 verschiedene Module 11 für die Schnittstellenkommunikation, für Ein- und Ausgabegeräte 12, Verarbeitungseinheiten 13 sowie die Energieversorgung 14 des Produktes. Die Bauteile einzelner Kategorien unterscheiden sich hinsichtlich ihrer funktionalen Leistungsmerkmale als auch hinsichtlich wirtschaftlicher Kenngrößen, Anschlussstellen sowie gegebenenfalls weiteren Parametern voneinander. Die Bibliothek 10 soll nicht auf die beispielhaft genannten Kategorien begrenzt sein.

Figur 4 zeigt ein mögliches Szenario. Der Kunde wünscht ein elektronisches Gerät bzw. einen Schaltaufbau für die Integration in eine Maschine, beispielsweise einen Kran, Mobilkran, Raupenbagger, etc. Für die Einbindung sind bestimmte Voraussetzungen zu erfüllen, die von dem Kunden bzw. dem Produktentwickler in der Produktsuchanfrage spezifiziert werden. Beispielsweise wird hier eine bestimmte Mikrocontroller-Architektur, die Festlegung auf digitale bzw. analoge Schaltungsfunktionen, Art und Umfang der Anschlussstellen, usw. festgelegt.

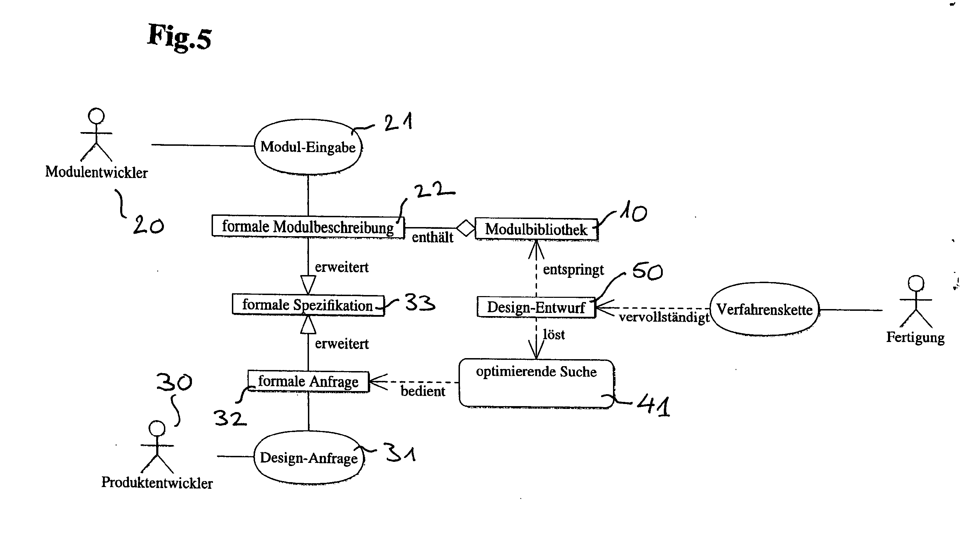

Der Ablauf des erfindungsgemäßen Verfahrens verdeutlicht die Diagrammdarstellung der Figur 5. Produkte, d.h. Design-Anfragen 31, sowie Teilmoduleingaben 21 werden mit ihren Anschlussstellen, funktionalen Beschreibungen, wirtschaftlichen Kenngrößen und Dokumentationsreferenzen in einer formalen Sprache in strenger, vorgegebener Form als formale Anfrage 32 bzw. formale Modulbeschreibung 22 erfasst. Die formale Spezifikation 33 ist eine Sammlung von allgemeinen Einschränkungen, funktionellen Beschreibungen und Anschlusspunkten. Die formale Teilschaltungsbeschreibung für die Baugruppen ist um eine Designdokumentation erweitert. Die formale Anfrage 32 ist um Entwürfe für die Realisierung durch Baugruppen erweitert. Diese Entwürfe 50 werden in der Ausführung vom Algorithmus 41 aus der Modulbibliothek 10 generiert.

Der Teil der formalen Sprache für die funktionale Beschreibung von Baugruppen und Produkten basiert auf Verbandsautomaten. Diese sind endliche Automaten, deren Alphabet partiell geordnet ist, und das System qualitativ, zeitlos modellieren. Das liefert das entscheidende Kriterium des funktionellen Vergleichs zwischen möglichen Entwürfen 50 und formalen Anfragen 32.

Das Kriterium für funktionelle Vergleiche angewandt auf einen durchsuchbaren Raum möglicher Schaltungen aus den gegebenen Baugruppen der Bibliothek 10 erzeugt eine Liste zu jeder Produktsuchanfrage an den Datenbestand. Die Struktur der Daten und der Bestand der Daten selbst ist dabei das Ergebnis einer Formalisierung von Entwicklungswissen, deren Erstellung, Form und Inhalt den Erfolg von Anfragen bestimmt.

Das Kombinationsverfahren des Kombinationsmoduls 40 basiert auf einem Algorithmus für die Lösung eines kombinatorischen Optimierungsproblems 41 mit mehreren Zielkomponenten. Dabei ist die Suchstrategie die Breitensuche mit einer Warteschlange von Teilproblemen erweiterbarer Netzlisten. Der Algorithmus verwendet generische Entscheidungskriterien (Heuristiken), die auf die Anwendung für elektronische Designs angepasst sind. Der durchsuchte Raum ist beschränkt durch allgemeine Beschränkungen für die Kosten und für die Bewertungen von Baugruppen.

Die Urteile in den Heuristiken werden durch eine Sprache in strenger Form vorbereitet. Diese Form ist im Detailgrad so weit gefasst, dass alle relevanten Baugruppen unterscheidbar sind und so eng gefasst, dass kaum Mehrdeutigkeiten möglich sind. Der Detailgrad ist eine Ordnung der Reduktion bei der Modellbildung als formale Spezifikation. Die Form erlaubt die Skalierung der Baugruppen, indem die Beschreibung von Baugruppen der Beschreibung von Entwürfen für Produkte in den die Suche bestimmenden Aspekten gleicht. Daher können Baugruppen im Laufe der Nutzung ihrerseits aus kleineren Baugruppen erzeugt werden.

Die Prüfung der Spezifikationskonformität und Fehlerfreiheit wird unabhängig vom Nutzer anhand einer datenblatt- und messungsbasierten Datenstruktur automatisch durchgeführt. Am Ende steht ein Systementwurf 50 als Grundlage für die Verfeinerung und Kontrollstrukturen zur Verfügung. Die Verfeinerung der Kontrollstrukturen wird mit Referenzen auf Standardlösungen in der Dokumentation ergänzt.

Das erfindungsgemäße Verfahren zeichnet sich dadurch aus, dass systematische Fallunterscheidungen darin übertroffen werden, dass die Ergebnisse unter Berücksichtigung der Freiheitsgrade im elektronischen Design spezialisiert behandelt werden. Automatische Beweise werden darin übertroffen, dass die Rückwirkungen in elektronischen Baugruppen und ihren Verschaltungen mit Mitteln der Informatik, endliche Automatenmodelle durch Aussagenlogik und Mengenlehre, erfasst werden. Formale Funktionsbeschreibungen werden so erweitert, dass die Beschreibung unter Berücksichtigung von physikalischen und wirtschaftlichen Details effizient verarbeitet werden können.

Zusammenfassend zeichnet sich die Erfindung durch die Abstrahierung von elektronischen Schaltungsmodulen in Beschreibungen mit strenger, vorgegebener Form aus, sowie durch die Abstrahierung von elektronischen Produkten als Suchanfragen in strenger, vorgegebener Form. Der funktionelle Vergleich wird mithilfe von Verbandsautomaten ausgeführt. Der Algorithmus für die Erstellung für die Erstellung der Systementwürfe basiert auf einem Algorithmus für die Lösung kombinatorischer Optimierungsprobleme mit mehreren Zielen zur Auswahl von Modulen für eine Suchanfrage eines Produkts in strenger, vorgegebener Form. Weiterhin liegt eine Skalierbarkeit aufgrund der Verwandtschaft von Schaltungsbeschreibungen und Suchanfragen vor. Die Sprache in strenger, vorgegebener Form für die Spezifikation von Elektronik umfasst Klauseln für die Datenblattinformationen und Entwicklerheuristiken in einer Datenbank.

## Patentansprüche

1. Verfahren zum Entwurf einer elektronischen Schaltung für ein elektronisches Gerät unter Verwendung einer Datenbank, die ein oder mehrere Schaltungsteilmodule und/oder Schaltungssysteme enthält, die jeweils durch eine abstrakte Modul- und/oder Systemspezifikation in streng vorgegebener Form definiert sind, wobei
eine formale Produktsuchanfrage auf Grundlage einer abstrakten Produktspezifikation in streng vorgegebener Form durch den Nutzer eingegeben wird,
und ein Kombinatorikmodul in Abhängigkeit der Produktsuchanfrage aus ein oder mehreren Instanzen der gespeicherten Schaltungsteilmodule und/oder Schaltungssysteme ein oder mehrere Systementwürfe erstellt, insbesondere eine Liste von möglichen Systementwürfen erstellt.

2. Verfahren nach Anspruch 1, **dadurch gekennzeichnet, dass** die Liste an Systementwürfen auf Grundlage einer kombinatorischen Suche mit den Kombinationen mit Wiederholungen aus der Datenbank als Suchraum und der Produktsuchanfrage als Suchkriterium erstellt wird.

3. Verfahren nach Anspruch 2, **dadurch gekennzeichnet, dass** die Suchstrategie auf einer Breitensuche mit einer Warteschlange von Teilproblemen erweiterbarer Netzlisten basiert.

4. Verfahren nach einem der Ansprüche 2 oder 3, **dadurch gekennzeichnet, dass** die kombinatorische Suche Heuristiken verwendet, die auf die Anwendung für elektronische Designs angepasst sind.

5. Verfahren nach einem der vorhergehenden Ansprüche 2 bis 4, **dadurch gekennzeichnet, dass** der durchsuchte Raum durch allgemeine Beschränkungen für die Kosten und für die Bewertungen von Baugruppen beschränkt ist.

6. Verfahren nach einem der vorhergehenden Ansprüche, **dadurch gekennzeichnet, dass** die Produktspezifikation und/oder die Modul- und/oder Systemspezifikation eine funktionale Beschreibung und/oder allgemeine Einschränkungen und/oder Informationen über die Anschlussstellen umfasst.

7. Verfahren nach einem der vorhergehenden Ansprüche, **dadurch gekennzeichnet, dass** die funktionelle Beschreibung auf einer Modellierung der Module/Systeme unter Verwendung von endlichen Verbandsautomaten basiert.

8. Verfahren nach einem der Ansprüche 6 oder 7, **dadurch gekennzeichnet, dass** die allgemeinen Einschränkungen wirtschaftliche Kenngrößen und/oder Entwickler-Heuristiken umfassen.

9. Verfahren nach einem der Ansprüche 6 bis 8, **dadurch gekennzeichnet, dass** die Produktspezifikation und/oder Modul- und/oder Systemspezifikation Klauseln für Datenblatt-Informationen umfasst.

10. Verfahren nach einem der vorhergehenden Ansprüche, **dadurch gekennzeichnet, dass** die Liste geeigneter Systementwürfe zudem einen Vorschlag für deren mögliche Verschaltung enthält.

11. Vorrichtung zur Durchführung des Verfahrens nach einem der vorhergehenden Ansprüche.

12. Auf einem Datenträger gespeichertes Programm zur Durchführung des Verfahrens gemäß einem der Ansprüche 1 bis 10.
